# FASCICULE DE BREVET EUROPEEN

(11) **EP 0 993 760 B1**
(45) Date de publication et mention de la délivrance du brevet: **22.09.2004**
(21) Numéro de dépôt: 99916973.3
(22) Date de dépôt: 30.04.1999
(51) Int. Cl.: H05K 7/12

(54) **DISPOSITIF POUR LE BLOCAGE MECANIQUE D'UN COMPOSANT ELECTRONIQUE PAR RAPPORT A UN SUPPORT**
VORRICHTUNG ZUM MECHANISCHEN SPERREN EINES ELEKTRONISCHEN BAUTEILS AUF EINEM SUBSTRAT
DEVICE FOR MECHANICALLY LOCKING AN ELECTRONIC COMPONENT WITH RESPECT TO A SUPPORT

(30) Priorité: 30.04.1998 FR 9805529
(43) Date de publication de la demande: 19.04.2000
(73) Titulaire: VALEO CLIMATISATION, 78321 La Verrière (FR)
(72) Inventeur: PERMUY, Alfred, F-92500 Rueil Malmaison (FR)
(86) Numéro de dépôt international: PCT/FR1999/001043
(87) Numéro de publication internationale: WO 1999/057950

(56) Documents cités:
- EP-A- 0 788 155
- FR-A- 2 581 249
- US-A- 5 225 965

## Description

La présente invention est relative à un dispositif pour le blocage mécanique d'un composant électronique par rapport à un support.

Plus particulièrement, l'invention concerne les dispositifs qui sont utilisés, notamment dans le domaine de l'automobile, pour maintenir en place sur un support tel qu'une semelle métallique un composant qui est par ailleurs soudé à une carte à circuit imprimé qui est rapportée sur ledit support.

A l'heure actuelle, on connaît principalement deux types de techniques permettant le montage d'une telle structure.

Une première technique consiste à mettre en place le composant sur le support, à monter sur le support et le composant un dispositif mécanique permettant de bloquer la position dudit composant sur ledit support, puis à mettre en place la carte sur le support et enfin à souder le composant sur ladite carte.

Une autre technique consiste à souder d'abord les composants sur la carte, à mettre en place la carte sur le support, puis à mettre en place sur le support et le composant un dispositif mécanique permettant de bloquer la position du composant sur le support.

Toutefois, ces deux techniques présentent l'une et l'autre l'inconvénient de nécessiter des dégagements importants sur la carte pour permettre soit les opérations de soudure, soit la mise en place des dispositifs mécaniques de blocage.

De tels dégagements sont pénalisants puisqu'ils limitent la surface de la carte susceptible de porter des pistes, et ce au voisinage des composants, alors que certains composants, tels que les transistors de puissance, nécessitent de pouvoir disposer de pistes d'une largeur importante au voisinage des points de la carte où ils sont soudés.

Le dispositif de blocage et le procédé qui sont proposés par l'invention permettent de pallier ces inconvénients.

A cet effet, le dispositif de blocage qui est proposé par l'invention comporte une paroi principale destinée à être en appui contre une paroi du support et au moins une patte élastique formant un retour en U par rapport à ladite paroi principale, ladite paroi principale et ladite patte élastique portant des moyens complémentaires permettant de maintenir ladite patte dans une position où elle est comprimée vers ladite paroi principale, ces moyens complémentaires était aptes à être désengagés les uns par rapport aux autres, ladite patte élastique étant alors libérée pour venir en appui contre le composant.

En particulier, selon un mode de réalisation avantageux, la paroi principale est prolongée à son extrémité opposée à la patte élastique par un plateau en retour qui s'étend vers ladite patte, les moyens complémentaires qui permettent de maintenir ladite patte dans une position comprimée étant portés par ladite patte et par ledit plateau, lesdits moyens étant aptes à être désengagés sous l'effet d'un effort d'appui exercé par un opérateur, par un mécanisme de forme, par chauffage ou par refroidissement sur ledit plateau par l'intermédiaire d'un outil tel que, par exemple, un stylet.

Le procédé de montage qui est proposé par l'invention est quant à lui caractérisé en ce qu'on positionne sur ledit support un dispositif du type précité, de façon que sa paroi principale soit en appui contre une paroi dudit support et que la (ou les) patte(s) dudit dispositif se trouve(nt) en regard d'un logement destiné à recevoir un composant à bloquer, ladite (ou lesdites) patte(s) étant comprimée(s) vers la paroi principale, en ce qu'on rapporte la carte à circuit imprimé sur ledit support, le composant ayant été préalablement soudé à celle-ci et étant alors mis en place dans ledit logement et en ce que la (ou les) patte(s) du dispositif soi(en)t libéré(es) au moyen d'un outil (ST) pour qu'elle(s) vienne(nt) en appui contre le composant.

Notamment, dans le cas où le dispositif de blocage présente un plateau en retour, pour désengager les moyens maintenant la (ou les) patte(s) dans une position comprimée vers la paroi principale, l'opérateur engage son outil dans un orifice que présente la carte à circuit imprimé et exerce avec cet outil un effort d'appui sur le plateau en retour que présente le dispositif.

D'autres caractéristiques et avantages de l'invention ressortiront encore de la description qui suit. Cette description est purement illustrative et non limitative. Elle doit être lue en regard des figures annexées sur lesquelles :
- la figure 1 est une représentation en perspective d'un dispositif conforme à un mode de réalisation de l'invention ;
- la figure 2 est une représentation en vue en coupe du dispositif de la figure 1 dans le cas où les pattes dudit dispositif sont dans leur position comprimée
- la figure 3 illustre le montage de la carte à circuit imprimée sur le support.

Le dispositif illustré sur ces figures est une pièce formant ressort qui présente une paroi principale 1 destinée à être adossée à une paroi complémentaire d'un support, ainsi que deux pattes élastiques parallèles 2a et 2b qui prolongent ladite paroi 1 en formant chacune un retour en U par rapport à celle-ci.

A son extrémité opposée aux pattes élastiques 2a et 2b, la paroi 1 est également prolongée d'une part par un retour qui définit un plateau central 3 et qui s'étend de façon sensiblement perpendiculaire par rapport à la paroi 1 et d'autre part par deux languettes de positionnement 5a, 5b qui s'étendent dans le prolongement de la paroi 1 et dans le plan de celle-ci, de part et d'autre du plateau 3.

Le bord du plateau 3 opposé à la paroi 1 porte deux ergots 4a et 4b formant crochets qui sont répartis en regard de deux ouvertures 6a et 6b que présentent les pattes 2a et 2b et avec lesquelles lesdits ergots 4a et 4b sont destinés à coopérer pour maintenir lesdites pattes 2a et 2b dans une position où celles-ci sont comprimées vers ladite paroi 1.

Les languettes 5a et 5b se terminent par des rebords 7a, 7b recourbés qui permettent de caler le dispositif par rapport au bord de la paroi sur laquelle il vient en appui, le dispositif se positionnant ainsi nécessairement à une hauteur donnée par rapport à ladite paroi.

Bien que cela n'ait pas été représenté, il est également possible de prévoir sur le dispositif et sur le support des moyens, tels que des ailettes et des rails de guidage complémentaires, permettant de prédéfinir la position du dispositif par rapport à la direction transversale de la paroi du support sur laquelle il vient en appui.

Le montage d'une carte à circuit imprimé sur un support en utilisant un tel dispositif de blocage va maintenant être décrit.

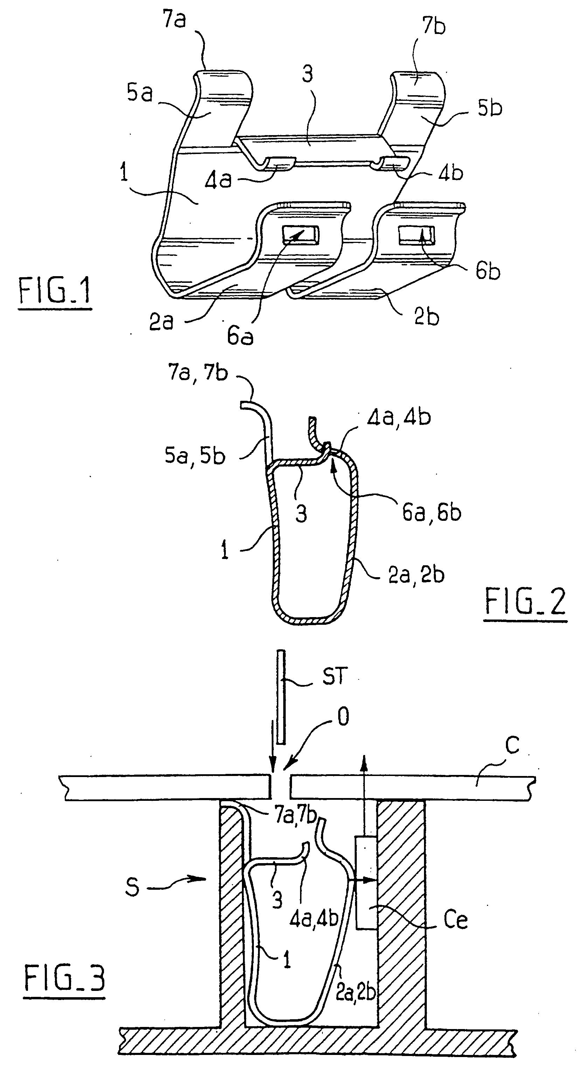

Les pattes 2a et 2b sont initialement comprimées vers la paroi 1 (figure 2), en étant maintenues dans cette position par la coopération des ergots formant crochet 4a, 4b et des ouvertures 6a, 6b.

Dans cette position comprimée, le dispositif est mis en place sur la paroi S du support sur laquelle il est destinée à prendre appui (figure 3). Ainsi que cela a déjà été indiqué, le support est par exemple une semelle métallique.

Notamment, il est glissé le long de cette paroi S jusqu'à ce que les rebords 7a et 7b viennent en appui sur le rebord de ladite paroi.

La carte électronique C est ensuite mise en place sur le support.

Les composants électroniques Ce ont été préalablement soudés à celle-ci.

Lors de la mise en place de la carte C, les composants électroniques Ce se positionnent dans les évidements du support qui sont destinés à les recevoir.

Puis un opérateur vient, au moyen d'un outil adéquat, tel qu'un stylet ST qu'il passe à travers un orifice O que présente la carte C (flèche sur la figure 3), appuyer sur le plateau 3 qui se déforme élastiquement et libère les pattes 2a, 2b par rapport aux ergots 4a et 4b.

Lesdites pattes 2a et 2b viennent en appui sur le composant électronique Ce en face duquel elles se trouvent (figure 3). Elles exercent sur celui-ci un effort élastique qui le repousse contre une autre paroi du support. Lesdites pattes 2a et 2b réalisent ainsi un blocage du composant par rapport au support et empêche notamment que ledit composant ne subisse des vibrations par rapport au support et à la carte.

Comme on l'aura compris, seul un orifice de petite dimension est nécessaire sur la carte pour faire passer le stylet.

On s'est placé dans la description qui précède dans le cas où le dispositif de blocage comporte deux pattes élastiques, ce qui correspond à un mode de réalisation avantageux. Bien entendu, le dispositif pourrait également ne comporter qu'une seule patte ou au contraire comporter un nombre de pattes supérieur à deux.

## Revendications

1. Dispositif pour le blocage mécanique par rapport à un support (S) d'un composant électronique (Ce) soudé à une carte ( C) à circuit imprimé qui est rapportée sur ledit support (S), carctérisé en ce qu'il comporte une paroi principale (1) en appui contre une paroi du support (S) et au moins une patte élastique (2a, 2b) formant un retour en U par rapport à ladite paroi principale (1), ladite paroi principale (1) et ladite patte élastique (2a, 2b) portant des moyens complémentaires (3 ; 4a, 4b; 6a, 6b) permettant de maintenir ladite patte (2a, 2b) dans une position où elle est comprimée vers ladite paroi principale (1), ces moyens complémentaires (3; 4a, 4b, 6a, 6b) étant aptes à être désengagés les uns par rapport aux autres, ladite patte élastique (2a, 2b) étant alors libérée pour venir en appui contre le composant (Ce).

2. Dispositif selon la revendication 1, **caractérisé en ce que** la paroi principale (1) est prolongée à son extrémité opposée à la patte élastique (2a, 2b) par un plateau (3) en retour qui s'étend vers ladite patte (2a, 2b), les moyens complémentaires (4a, 4b ; 6a, 6b) qui permettent de maintenir ladite patte (2a, 2b) dans une position comprimée étant portés par ladite patte (2a, 2b) et par ledit plateau (3) lesdits moyens étant aptes à être désengagés sous l'effet d'un effort d'appui exercé sur ledit plateau (3) par l'intermédiaire d'un outil tel qu'un stylet (ST).

3. Dispositif selon l'une des revendications précédentes, **caractérisé en ce que** les moyens permettant de maintenir la patte dans une position comprimée par rapport à la paroi principale comportent au moins un ergot formant crochet (4a, 4b) et une ouverture complémentaire (6a, 6b).

4. Dispositif selon l'une des revendications précédentes, **caractérisé en ce qu'**il comporte des moyens (7a, 7b) pour guider son positionnement par rapport à la paroi du support contre laquelle il vient en appui.

5. Dispositif selon la revendication 4, **caractérisé en ce que** ces moyens comportent au moins un rebord de positionnement (7a,7b) qui prolonge la paroi principale (1) et est destiné à venir en appui contre un rebord de la paroi du support (S).

6. Dispositif selon les revendications 2 et 5 prises en combinaison, **caractérisé en ce qu'**il comporte deux languettes (5a, 5b) qui s'étendent dans le prolongement de la paroi principale (1), de part et d'autre du plateau (3) en retour, et qui se terminent chacune par un rebord de positionnement (7a, 7b).

7. Dispositif selon l'une des revendications précédentes, **caractérisé en ce qu'**il comporte une pluralité de pattes élastiques (2a, 2b) en retour en U par rapport à la paroi principale (1).

8. Dispositif selon la revendication 7, **caractérisé en ce qu'**il comporte deux pattes élastiques (2a, 2b) formant un retour en U par rapport à la paroi principale (1).

9. Procédé de montage d'une carte à circuit imprimé (C) sur un support, **caractérisé en ce qu'**on positionne sur ledit support un dispositif selon l'une des revendications précédentes, de façon que sa paroi principale (1) soit en appui contre une paroi (1) dudit support et que la (ou les) patte(s) (2a, 2b) étant comprimée(s) vers la paroi principale (1), **en ce qu'**on rapporte la carte à circuit imprimé (C) sur ledit support (S), le composant (Ce) ayant été préalablement soudé à celle-ci et étant alors mis en place dans ledit logement et **en ce que** la (ou les) patte(s) du dispositif soi(en)t libérée(s) au moyen d'un outil (ST) pour qu'elles vienne(nt) en appui contre le composant (Ce).

10. Procédé de montage selon la revendication 9, **caractérisé en ce que** le dispositif est du type selon la revendication 2 et **en ce que** pour désengager les moyens maintenant la (ou les) patte(s) (2a, 2b) dans une position comprimée vers la paroi principale (1), l'opérateur engage son outil (ST) dans un orifice (O) que présente la carte à circuit imprimé (C) et exerce avec cet outil un effort d'appui sur le plateau (3) en retour que présente le dispositif.

## Claims

1. Device for the mechanical locking, relative to a support (S), of an electronic component (Ce) welded to a printed circuit board (C) mounted on the said support (S), **characterized in that** it comprises a main wall (1) bearing against a wall of the support (S) and at least one elastic bracket (2a, 2b) forming a U-turn relative to the said main wall (1), the said main wall (1) and the said elastic bracket (2a, 2b) bearing complementary means (3; 4a, 4b; 6a, 6b) by which the said bracket (2a, 2b) can be held in a position in which it is compressed towards the said main wall (1), these complementary means (3; 4a, 4b, 6a, 6b) being capable of being disengaged from one another, the said elastic bracket (2a, 2b) being then liberated so as to come to bear against the component (Ce).

2. Device according to Claim 1, **characterized in that** the main wall (1) is extended at its end opposite to the elastic bracket (2a, 2b) by a turn plate (3) extending towards the said bracket (2a, 2b), the complementary means (4a, 4b; 6a, 6b) by which the said bracket (2a, 2b) can be held in a compressed position being borne by the said bracket (2a, 2b) and by the said plate (3), the said means being capable of being disengaged under the influence of a bearing force exerted upon the said plate (3) by way of a tool such as a stylet (ST).

3. Device according to one of the preceding claims, **characterized in that** the means by which the bracket can be held in a compressed position relative to the main wall comprise at least one hook-forming lug (4a, 4b) and a complementary opening (6a, 6b).

4. Device according to one of the preceding claims, **characterized in that** it comprises means (7a, 7b) for guiding its positioning relative to the wall of the support against which it comes to bear.

5. Device according to Claim 4, **characterized in that** these means comprise at least one positioning lip (7a, 7b) which extends the main wall (1) and is intended to come to bear against a lip of the wall of the support (S).

6. Device according to Claims 2 and 5 taken in combination, **characterized in that** it comprises two tongues (5a, 5b) extending in the extension of the main wall (1) on either side of the turn plate (3) and each terminating in a positioning lip (7a, 7b).

7. Device according to one of the preceding claims, **characterized in that** it comprises a plurality of elastic brackets (2a, 2b) forming a U-turn relative to the main wall (1).

8. Device according to Claim 7, **characterized in that** it comprises two elastic brackets (2a, 2b) forming a U-turn relative to the main wall (1).

9. Process for assembling a printed circuit board (C) on a support, **characterized in that** a device according to one of the preceding claims is positioned on the said support such that its main wall (1) bears against a wall (1) of the said support and such that the bracket(s) (2a, 2b) is/are compressed towards the main wall (1), **in that** the printed circuit board (C) is mounted on the said support (S), the component (Ce) having previously been welded to the latter and being in this case installed in the said seat, and **in that** the bracket(s) of the device is/are liberated by means of a tool (ST) so as to come to bear against the component (Ce).

10. Assembly process according to Claim 9, **characterized in that** the device is of the type according to Claim 2 and **in that**, in order to disengage the means holding the bracket (s) (2a, 2b) in a compressed position towards the main wall (1), the operator engages his tool (ST) in an orifice (O) belonging to the printed circuit board (C) and exerts with this tool a bearing force upon the turn plate (3) belonging to the device.

## Patentansprüche

1. Vorrichtung zur mechanischem Blockierung eines an eine Leiterplatte (C) geschweißten elektronischen Bauteils (Ce) bezüglich eines Trägers (S), wobei die Leiterplatte auf den Träger (S) aufgesetzt ist, **dadurch gekennzeichnet, dass** sie eine Hauptwand (1), die gegen eine Wand des Trägers (S) anliegt, und mindestens eine elastische Lasche (2a, 2b) aufweist, die einen U-förmigen Umschlag bezüglich der Hauptwand (1) bildet, wobei die Hauptwand (1) und die elastische Lasche (2a, 2b) komplementäre Mittel (3; 4a, 4b; 6a, 6b) tragen, die es ermöglichen, die Lasche (2a, 2b) in einer Stellung zu halten, in der sie gegen die Hauptwand (1) zusammengedrückt ist, wobei diese komplementären Mittel (3; 4a, 4b, 6a, 6b) voneinander gelöst werden können, wobei die elastische Lasche (2a, 2b) dann freigegeben wird, um gegen das Bauteil (Ce) in Anlage zu kommen.

2. Vorrichtung nach Anspruch 1, **dadurch gekennzeichnet, dass** die Hauptwand (1) an ihrem der elastischen Lasche (2a, 2b) entgegengesetzten Ende von einer umgebogenen Platte (3) verlängert wird, die sich zur Lasche (2a, 2b) hin erstreckt, wobei die komplementären Mittel (4a, 4b; 6a, 6b), die es ermöglichen, die Lasche (2a, 2b) in einer zusammengedrückten Stellung zu halten, von der Lasche (2a, 2b) und der Platte (3) getragen werden, wobei diese Mittel unter der Wirkung einer auf die Platte (3) mittels eines Werkzeugs, wie zum Beispiel einer Spitze (ST), ausgeübten Druckkraft voneinander gelöst werden können.

3. Vorrichtung nach einem der vorhergehenden Ansprüche, **dadurch gekennzeichnet, dass** die Mittel, die es ermöglichen, die Lasche bezüglich der Hauptwand in einer zusammengedrückten Stellung zu halten, mindestens einen einen Haken bildenden Vorsprung (4a, 4b) und eine komplementäre Öffnung (6a, 6b) aufweisen.

4. Vorrichtung nach einem der vorhergehenden Ansprüche, **dadurch gekennzeichnet, dass** sie Mittel (7a, 7b) aufweist, um ihre Positionierung bezüglich der Wand des Trägers zu führen, gegen die sie in Anlage kommt.

5. Vorrichtung nach Anspruch 4, **dadurch gekennzeichnet, dass** diese Mittel mindestens eine Positionier-Randleiste (7a, 7b) aufweisen, die die Hauptwand (1) verlängert und dazu bestimmt ist, gegen eine Randleiste der Wand des Trägers (S) in Anlage zu kommen.

6. Vorrichtung nach den Ansprüchen 2 und 5 zusammen gesehen, **dadurch gekennzeichnet, dass** sie zwei Zungen (5a, 5b) aufweist, die sich in der Verlängerung der Hauptwand (1) zu beiden Seiten der umgebogenen Platte (3) erstrecken und je in einer Positionier-Randleiste (7a, 7b) enden.

7. Vorrichtung nach einem der vorhergehenden Ansprüche, **dadurch gekennzeichnet, dass** sie mehrere elastische Laschen (2a, 2b) aufweist, die in Bezug auf die Hauptwand (1) U-förmig umgebogen sind.

8. Vorrichtung nach Anspruch 7, **dadurch gekennzeichnet, dass** sie zwei elastische Laschen (2a, 2b) aufweist, die in Bezug auf die Hauptwand (1) U-förmig umgebogen sind.

9. Verfahren zur Montage einer Leiterplatte (C) auf einem Träger, **dadurch gekennzeichnet, dass** man auf dem Träger eine Vorrichtung gemäß einem der vorhergehenden Ansprüche derart positioniert, dass ihre Hauptwand (1) gegen eine Wand (1) des Trägers anliegt, und dass die Lasche(n) (2a, 2b) gegen die Hauptwand (1) zusammengedrückt ist (oder sind), dass man die Leiterplatte (C) auf den Träger (S) aufsetzt, wobei das Bauteil (Ce) vorher an diese geschweißt wurde und dann im Sitz angeordnet wird, und dass die Lasche(n) der Vorrichtung mit Hilfe eines Werkzeugs (ST) freigegeben wird (werden), damit sie gegen das Bauteil (Ce) in Anlage kommt (kommen).

10. Montageverfahren nach Anspruch 9, **dadurch gekennzeichnet, dass** die Vorrichtung von der Art gemäß Anspruch 2 ist, und dass die Bedienungsperson zum Lösen der Mittel, die die Lasche(n) (2a, 2b) in einer zur Hauptwand (1) hin zusammengedrückten Stellung halten, ihr Werkzeug (ST) in eine in der Leiterplatte (C) vorhandene Öffnung (O) einführt und mit diesem Werkzeug eine Druckkraft auf die umgebogene Platte (3) der Vorrichtung ausübt.
